Europäisches Patentamt

European Patent Office

Office européen des brevets

(11) Publication number: **0 201 686 B1**

# EUROPEAN PATENT SPECIFICATION

(45) Date of publication of patent specification: **20.02.91**

(51) Int. Cl.⁵: **H01L 29/205**, H01L 29/72

(21) Application number: **86103408.0**

(22) Date of filing: **13.03.86**

(54) Semiconductor device comprising a superlattice.

(30) Priority: **15.03.85 JP 52973/85**

(43) Date of publication of application:
**20.11.86 Bulletin 86/47**

(45) Publication of the grant of the patent:
**20.02.91 Bulletin 91/08**

(84) Designated Contracting States:
**DE FR GB NL**

(56) References cited:
**EP-A- 0 124 924**
**EP-A- 0 125 738**
**US-A- 4 261 771**

**JAPANESE JOURNAL OF APPLIED PHYSICS,
vol. 23, no. 8, part 2, August 1984, pages
L521-L523, Tokyo, JP; T. FUKUI et al.:
"(InAs)1(GaAs)1 layered crystal grown by
MOCVD"**

**JAPANESE JOURNAL OF APPLIED PHYSICS,
vol. 22, no. 11, November 1983, pages
L680-L682, Tokyo, JP; T. YAO: "A new high-
electron mobility monolayer superlattice"**

(73) Proprietor: **SONY CORPORATION**
**7-35 Kitashinagawa 6-Chome Shinagawa-ku
Tokyo 141(JP)**

(72) Inventor: **Ishibashi, Akira**
**c/o Sony Corporation 6-7-35 Kitashinagawa
Shinagawa-ku Tokyo(JP)**
Inventor: **Mori, Yoshifumi**
**c/o Sony Corporation 6-7-35 Kitashinagawa
Shinagawa-ku Tokyo(JP)**
Inventor: **Itabashi, Masao**
**c/o Sony Corporation 6-7-35 Kitashinagawa
Shinagawa-ku Tokyo(JP)**

(74) Representative: **TER MEER - MÜLLER - STEIN-
MEISTER & PARTNER**
**Mauerkircherstrasse 45**
**D-8000 München 80(DE)**

PATENTS ABSTRACTS OF JAPAN, vol. 7, no. 222 (E-201)[1367], 4th October 1983; & JP - A - 58 114 455

JOURNAL OF ELECTRONIC ENGINEERING, vol. 19, no. 187, July 1982, pages 28-31, Tokyo, JP; T. SAKAMOTO: "Moving toward future electron devices"

JOURNAL OF APPLIED PHYSICS, vol. 54, no. 11, November 1983, pages 6725-6731, American Institute of Physics,New York, US; S.L. SU et al.: "Double heterojunction GaAs/AlxGa1-xAs bipolar transistors prepared by molecular beam epitaxy"

## Description

The invention relates to a bipolar transistor of a vertical mesa structure such as a heterojunction type bipolar transistor.

In order to increase the operational speed of semiconductor devices such as bipolar transistors it is desirable that the electron mobility is increased. In order to enhance the electron mobility, a method is known for increasing the purity of a semiconductor layer in the electron active region of the device, or a method is used for avoiding the impurity scattering by utilizing a two-dimensional electron gas layer.

Although it is desirable to enhance the electron mobility, and the above mentioned various methods are proposed to realize this purpose, the electron mobility near room temperature is determined in practice by electron scattering caused by the LO phonon (LO = longitudinal optical). Therefore, with the known methods it can not be expected to realize an adequately high electron mobility.

Primarily for pn-semiconductor lasers it is known from documents EP-A-O 124 924 and EP-A-O 125 738, to use a superlattice arrangement of the electron-active region composed of chemical compound couples like GaAs/AlAs each having a thickness of a few monolayers. Any particular hints for the usefulness of such a structure for other semiconductor devices with different specific characteristics can not be derived from this prior art.

Superlattice monolayer depositions for achieving high electron mobility are also known for other semiconductor devices like X-ray reflectors (US-A-42 61 771) or for FET-structures(Japanese Journal of Applied Physics, Vol. 22, No. 11 November 1983, pages L 680-L 682) showing again that bipolar transistors were not considered to be a technical field for which extremely thin superlattice structures could be useful for improving the switching time or the operational speed of such semiconductor devices.

An object of the present invention is to provide an improved bipolar transistor useful for extremely high operational speeds.

A bipolar transistor of a vertical mesa structure according to the invention is characterized in that at least part of the base as the electron active region (6) of the transistor is composed of a superlattice semiconductor layer structure (2) consisting of a plurality of laminated different semiconductor layers $(L_1, L_2, ... L_n)$ of a thickness $1 < N < 8$ of monolayers each containing a single atom semiconductor or a binary compound semiconductor N defining the number of monolayers, such that, on the one hand, the longitudinal optical phonon remains in a localized state with respect to the laminated layer direction in each semiconductor layer, and, on the other hand, the electron mobility in the main current direction is the direction across said superlattice semiconductor layer structure.

As result of the invention, it has been observed that an effect of de-localized state of the electron or a localized state of the LO phonon with respect to the laminated layer direction occurs in each semiconductor layer and it has further been observed that with respect to the electron mobility a modulation occurs by mutual action between said semiconductor layers, i.e. a main electron active direction results in the laminated layer direction of respective electron active semiconductor layer.

Objects of the invention, features and advantages thereof will become apparent from the following detailed description of a preferred embodiment taken in con-junction with the accompanying drawings.

Fig. 1 is a schematic cross-sectional view of the superlattice structure of a semiconductor device; Fig. 2 is a graph of measured results of a relationship between the number of atomic layers and the energy gap;

Fig. 3 to 6 are respectively a graphic depictions of measured results of the number of atomic layers and LO phonon energies used to explain specific advantages of the invention;

Fig. 7 is a diagram showing a wave function of a phonon in the superlattice structure portion; and

Fig. 8 is a schematically enlarged cross-sectional view or an embodiment of a bipolar transistor of a vertical mesa structure according to the present invention.

The present invention in a bipolar transistor of a vertical mesa structure in the electron active region, resides in the use of a heterostructure superlattice having a periodic structure in which a plurality of different semiconductor layers are repeatedly laminated, based on the search result that when a semiconductor layer is formed as an ultrathin layer, i.e. a thin layer having a thickness less than 8 mono-layers, it exhibits a property which is different from the Kronig-Penney electron model, i.e. the electrons are delocalized and the LO phonon can be localized.

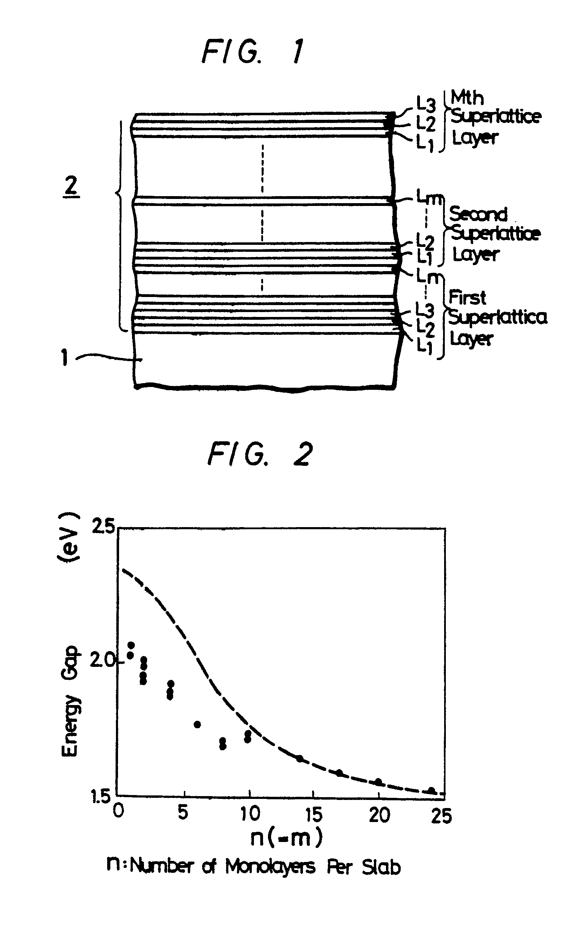

Specifically, as shown in Fig. 1, on a substrate 1, there is formed a semiconductor layer 2 having a superlattice structure such that a plurality of different semiconductor layers $L_1$, $L_2$, $L_3$, ... $L_n$ made of less than 8 monolayers each containing a single atom semiconductor or binary compound semiconductor and which are epitaxially grown alternately and repeatedly laminated with a plurality of periodic layer numbers M by the MOCVD (Metal Organic Chemical Vapour Deposition) method or by the MBE (Molecular Beam Epitaxy) method, whereby the whole or part of an electron active region is constructed. Thus a semiconductor device is achieved having a main electron active region direction crossing these semiconductor substance layers $L_1$, $L_2$, $L_3$,....

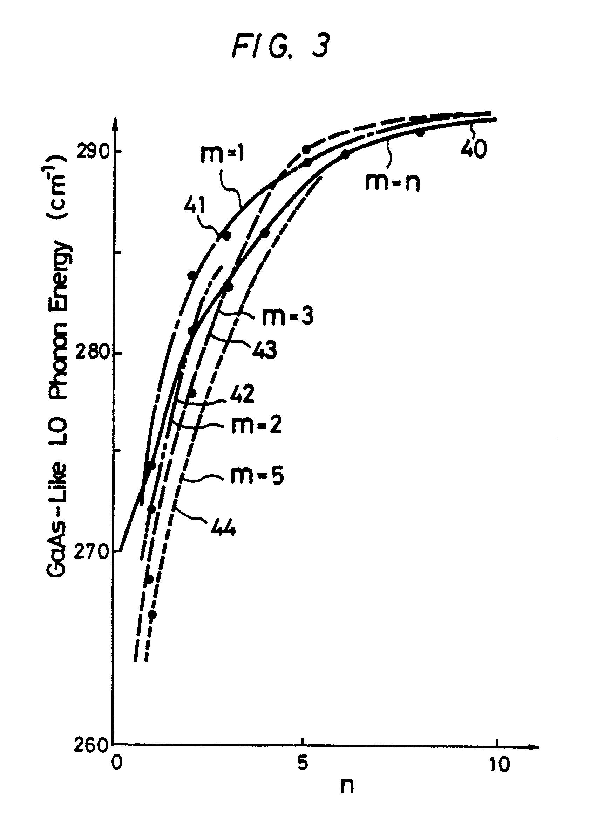

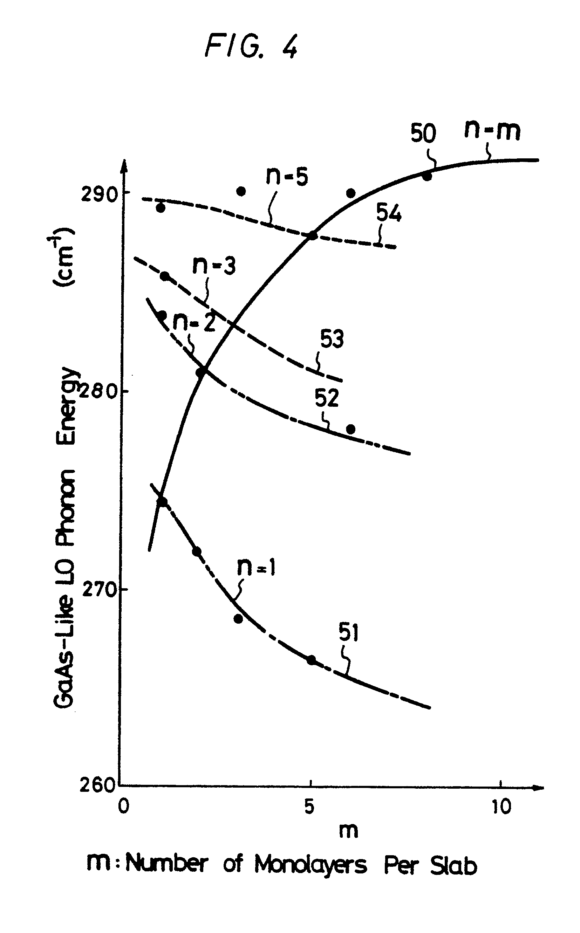

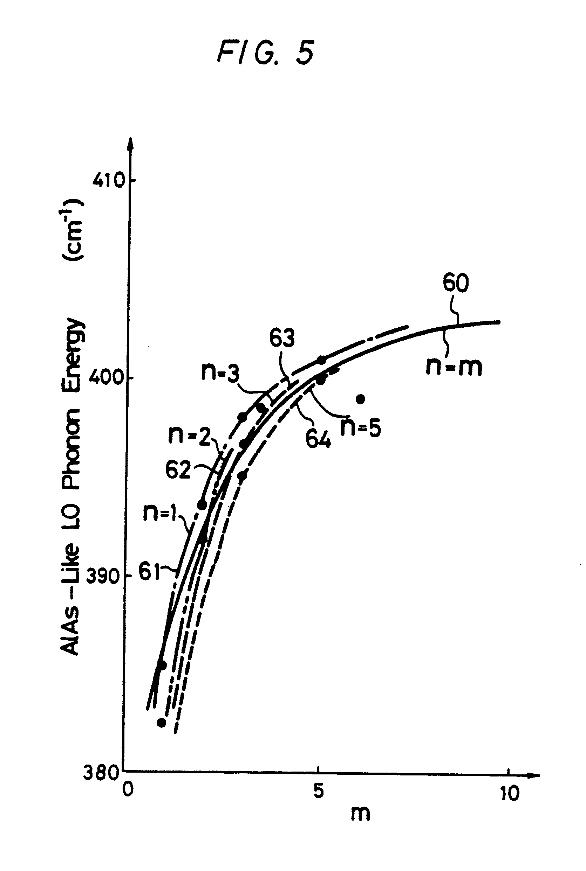

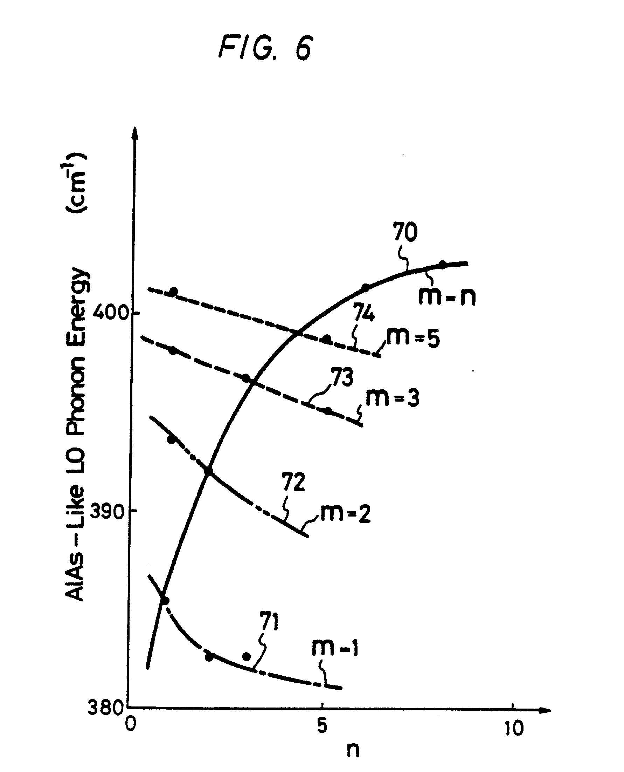

The semiconductor layer 2 is made of (AlAs)m (GaAs)n and is formed on the Cr doped semiinsulating GaAs substrate 1 by alternately producing m and n monolayers of two kinds of compound semiconductors AlAs and GaAs to have an entire thickness of 130 to 250 nm at a substrate temperature of 720 to 750°C by switcha bly supplying arsine (AsH₃), trimethylaluminum (TMA) or trimethylgallium (TMG) gas as a material gas according to the MOCVD. The energy gaps thereof were measured when n was changed under the condition that m = n was established. The results are plotted as black dots in Fig. 2. In Fig. 2, a broken line curve indicates the energy gaps that are provided by calculation based on the Kronig-Penney electron model theory. As will be clear by comparison, when n < 8, the plotted values do not coincide with those in the Kronig-Penney electron model. The reason for this is that when n( = m) < 8, the electron is not localized any more and the electron can be conducted in the laminate direction of the layer without the tunnel effect. Further, in the above mentioned semiconductor layer formed of (AlAs)m (GaAs)n, the Raman scattering experiment was carried out. The measurement was carried out by using an excitation light having a wavelength of 514,5nm and a Raman light scattered to the backward was measured by a double-monochromatic spectrometer at room temperature. Fig. 3 shows the measured results of the dependence of GaAs-like LO phonon energy in the (AlAs)m (GaAs)n on the value of n. In Fig. 3. the curve 40 indicates the case where m = n is established and curves 41 to 44 indicate the cases where m = 1, m = 2, m = 3 and m = 5 are established, respectively. According to the graph, the GaAs-like LO phonon energy is determined not by the value of m but the value of n. that is. the GaAs monolayer. Fig. 4 shows measured results of the dependence of the GaAs-like LO phonon on the value m. In Fig. 4, a curve 50 indicates the case where the value m is varied when m = n is established. Curves 51 to 54 indicate the cases where n = 1, n = 2, n = 3 and n = 5 are established, respectively. According to the graph, as will be clear from the comparison of the respective curves 51 to 54 each taking n as a parameter, although the GaAs-like LO phonon energy is varied considerably as n is varied, the respective curves 51 to 54 present gentle inclinations. In other words, they have small dependence on the value m. Fig. 5 shows measured results of the dependence of AlAs-like LO phonon energy in the (AlAs)m (GaAs)n on m. In Fig. 5, a curve 60 indicates the case where m = n is established and curves 61 to 64 indicate the cases where n = 1, n = 2, n = 3 and n = 5 are established, respectively. According to the graph, the energy of the AlAs-like LO phonon is determined not by the value n but the value m, that is, the AlAs monolayer. Fig. 6 shows measured results of the dependence of AlAs-like LO phonon on the value n. In Fig. 6, a curve 70 indicates a case where the value n is varied when m = n is established, and curves 71 to 74 indicate measured results in the cases where m = 1, m = 2, m = 3 and m = 5 are established, respectively. Accordingly, as will be clear from the comparison of the respective curves 71 to 74 each having m as a parameter, although the AlAs-like LO phonon energy is varied significantly as the value m is varied, the respective curves 71 to 74 present gentle inclinations. In other words, they have small dependence on the value n.

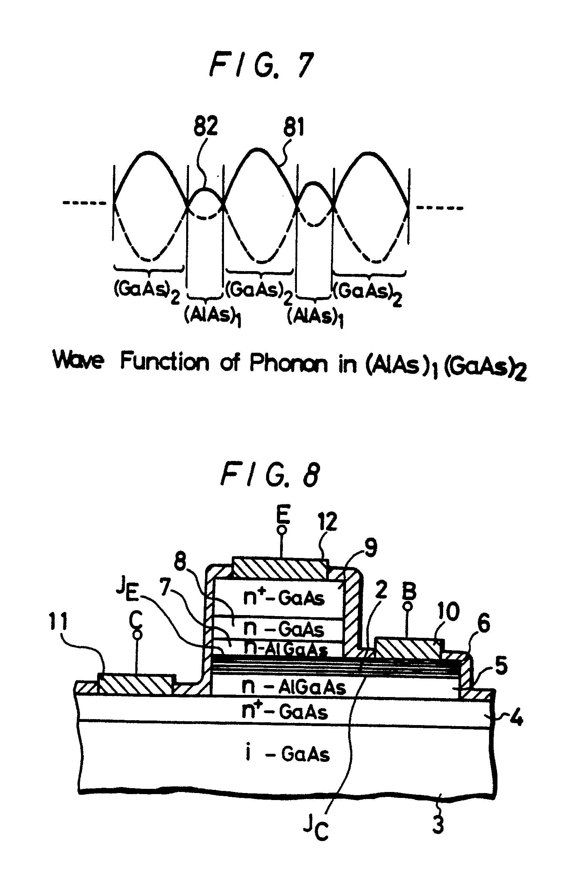

As will be clear from Figs. 3 to 6, the GaAs-like phonon energy is not dependent on the number m of the AlAs monolayers but is determined by the number n of the GaAs monolayers, while the AlAs-like phonon energy is not dependent on the number of the GaAs monolayers but is determined by the number m of the AlAs monolayers. In other words, the LO phonons are localized in the GaAs layer and the AlAs layer, respectively. That is, as, for example, shown by wave functions in (AlAs)₁ - (GaAs)₂ in Fig. 7, respective wave functions of the GaAs-like phonon and AlAs-like phonon are standing waves which are localized in the GaAs layer and the AlAs layer as shown by curves 81 and 82, respectively.

Specifically, the GaAs-like phonon and the AlAs-like phonon are respectively localized and the kinetic momenta thereof are modulated by the values n and m, respectively.

According to the present invention as mentioned above, the LO phonon is localized by the superlattice structure having less than 8 monolayers and the kinetic momentum thereof is modulated, accordingly, the scattering probability concerning the electron is modulated, whereby it is possible to realize a high speed semiconductor device. The LO phonon-electron scattering probability W can be expressed by using a LO phonon-electron scattering matrix element: $M_{LO-e}$ and the phase space p (f) as follows.

$$W = (2\pi/\hbar)\ p\ (f)\ |\ M_{LO-e}|^2\delta(Ef-Ei)\ ...(1)$$

$\hbar$ = h/2 wherein h is the Planck's constant)

$M_{LO-e}$ is proportional to the reciprocal number of the momentum.

However, as described above, since the phonon wave function is a standing wave, the momentum that the phonon can take in the final state is restricted considerably. Therefore, $M_{LO-e}$ in the aforesaid superlattice is smaller than than in the bulk. Accordingly, the scattering probability of the electron by the LO phonon becomes very small so that the modulation of the electron mobility occurs.

The present invention will be described more fully by an example with reference to Fig. 8, in which the present invention is applied to a heterojunction type bipolar transistor (HBT). The illustrated example is a npn-type HBT. In this case, for example, on a GaAs substrate 3 with semiinsulating property, there is epitaxially grown, for example, a n-type GaAs collector electrode deriving layer 4 having a low resistivity on which a collector layer 5 of, for example, an n-type AlGaAs semiconductor layer having a large band-gap, which forms a collector pn junction Jc of a hetero type,between it and a base layer 6 which will be mentioned later, is epitaxially grown. Next, on this collector layer 5, the afore-mentioned base layer 6 is epitaxially grown with a superlattice structure semiconductor layer 2 on which an epitaxial emitter layer 7 made of an n type AlGaAs having a large band-gap is formed. On this layer 7, there is epitaxially grown, for example, a n type GaAs semiconductor layer 8 to thereby form an emitter junction $J_E$ of a heterojunction type, i.e. a pn junction between the emitter layer 7 and the base layer 6. Further, thereon there is epitaxially grown an emitter electrode deriving layer 9 made of, for example, an n-type GaAs semiconductor layer with low resistivity. These layers 4 to 9 are continuously formed by MOCVD. Parts of the semiconductor layers 9, 8 and 7 are removed by etching to expose a part of the base layer 6 on which a base electrode 10 is deposited in ohmic contact. Further, parts of the semiconductor layers 9,8,7 and 6 are removed by etching to expose to the outside a part of the collector electrode deriving layer 4 on which a collector electrode 11 is deposited in ohmic contact and an emitter electrode 12 is deposited on the emitter electrode deriving region 9 in ohmic contact.

Since a HBT of such a structure comprises the base layer 6 which has the above mentioned superlattice structure having less than 8 atomic layers and a longitudinal structure in which the electron active direction is in the layer laminated direction of the superlattice structure, a very high electron mobility can be achieved as described before. Thus the switching speed can be increased and also the transport efficiency can be increased. Thus, it is possible to obtain a transistor with a high amplification factor.

According to the present invention as mentioned above, since the LO phonon can be localized, it is possible to achieve a modulation of the electron mobility that could not be expected from knowing the prior art.

## Claims

1. Bipolar transistor of a vertical mesa structure **characterized in that** at least part of the base as the electron active region (6) of the transistor is composed of a superlattice semiconductor layer structure (2) consisting of a plurality of laminated different semiconductor layers ($L_1$, $L_2$, ... $L_n$) of a thickness $1 < N < 8$ of monolayers each containing a single atom semiconductor or a binary compound semiconductor, n defining the number of monolayers, such that, on the one hand, the longitudinal optical phonon remains in a localized state with respect to the laminated layer direction in each semiconductor layer, and, on the other hand, the electron mobility in the main current direction is the direction across said superlattice semiconductor layer structure.

## Revendications

1. Transistor bipolaire à structure mesa verticale caractérisé en ce que : au moins une partie de la base, en tant que région électroniquement active (6) du transistor, est composée d'une structure de couche semiconductrice en super-réseau (2) qui est constistuée d'une pluralité de couches semiconductrices différentes empilées ($L_1$, $L_2$...$L_n$) d'une épaisseur égale à N couches monomoléculaires, $1 < N<8$, chaque couche monomoléculaire contenant un semiconducteur à une seule sorte d'atome ou un semiconducteur en un composé binaire, N définissant le nombre de couches monomoléculaires, de telle sorte que, d'une part, le phonon optique longitudinal reste dans un état localisé par rapport à la direction de la couche empilée de chaque couche semiconductrice, et de telle sorte que, d'autre part, la mobilité des électrons selon la direction principale du courant s'effectue selon la direction perpendiculaire à la structure formée par la couche semiconductrice en super-réseau.

## Ansprüche

1. Bipolarer Transistor mit vertikaler MESA-Struktur, **dadurch gekennzeichnet,** daß wenigstens ein Teil der Basis als elektronenaktiver Bereich (6) des Transistors aus einer Übergitter-Halbleiterschichtstruktur (2) besteht, die eine Mehrzahl von aufeinander liegenden, unterschiedlichen Halbleiterschichten ($L_1$, $L_2$....$L_n$) mit einer Dicke von $1 < N<8$ Monolagen aufweist, von denen jede einen einatomigen Halbleiter oder einen Binärverbund-Halbleiter enthält, wobei N die Anzahl der Monolagen angibt, und wobei einerseits das longitudinale optische Phonon in einem lokalisierten Zustand bezüglich der Schichtungsrichtung in jeder Halbleiterschicht verbleibt und andererseits die Hauptrichtung der Elektronenbeweglichkeit in Richtung der Übergitter-Halbleiterschichtstruktur verläuft.

## FIG. 1

L3 | Mth
L2 | Superlattice
L1 | Layer

2

Lm | Second
L2 | Superlattice
L1 | Layer

Lm | First
L3 | Superlattice
L2 | Layer
L1

1

## FIG. 2

n: Number of Monolayers Per Slab

# FIG. 3

FIG. 4

FIG. 5

FIG. 6

# F I G. 7

Wave Function of Phonon in $(AlAs)_1 (GaAs)_2$

# F I G. 8